Europäisches Patentamt

European Patent Office

Office européen des brevets

(19)

(11) Veröffentlichungsnummer: **0 045 882**
**B1**

(12) EUROPÄISCHE PATENTSCHRIFT

(45) Veröffentlichungstag der Patentschrift:
09.05.84

(51) Int. Cl.³: **H 03 K 4/64,** H 03 K 17/64,
H 02 M 3/335, H 04 N 3/16

(21) Anmeldenummer: 81105806.4

(22) Anmeldetag: 22.07.81

(54) **Elektrische Steuerschaltung.**

(30) Priorität: 11.08.80 DE 3030322

(43) Veröffentlichungstag der Anmeldung:
17.02.82 Patentblatt 82/7

(45) Bekanntmachung des Hinweises auf die Patenterteilung:
09.05.84 Patentblatt 84/19

(84) Benannte Vertragsstaaten:
DE FR GB IT

(56) Entgegenhaltungen:
FR - A - 1 538 297
US - A - 3 801 857

MORRIS B.: SEMICONDUCTOR CIRCUIT DESIGN. Band
4, 1975, Texas Instruments BEDFORD (GB) K. SALMON
et al.: "Use of high-voltage switching transistors",
Seiten 23-34
Elektronik, Nr. 3, 1976, Seiten 92-96, R.D. KLEIN
"Digitaler Sinusgenerator mit Festwertspeicher"

(73) Patentinhaber: SIEMENS AKTIENGESELLSCHAFT,
Berlin und München Wittelsbacherplatz 2,
D-8000 München 2 (DE)

(72) Erfinder: Dangschat, Rainer, Jahnstrasse 8,
D-8011 Landsham (DE)

## Beschreibung

Die Erfindung bezieht sich auf eine elektronische Steuerschaltung für die Horizontalablenkung eines Fernsehgeräts bzw. für ein Schaltnetzteil, bei der die Steuerelektrode eines den Ausgangsstrom der Steuerschaltung liefernden Ausgangstransistors durch wenigstens ein einen zeitlich veränderlichen Strom über die Steuerelektrode hervorrufendes Steuersignal beaufschlagt ist.

Eine übliche Steuerschaltung dieser Art ist in Fig. 1 dargestellt. Bei dieser wird der Ausgangstransistor über eine Treiberstufe gesteuert, die aus einem Treibertransistor mit nachfolgendem Treibertransformator besteht. Die Beaufschlagung des Treibertransistors ist dabei so getroffen, dass der Basisstrom des Ausgangstransistors sich entsprechend Fig. 2 oder Fig. 3 verhält. Dazu wird vorab folgendes bemerkt.

Der Transistor für die Horizontalablenkung in Farbfernsehempfängern, also ein Ausgangstransistor gemäss der obigen Definition, wird bei den üblichen Schaltungen über einen Treibertransformator mit einem Basisstrom von ca. 1A angesteuert. Dieser Basisstrom muss eine bestimmte Kurvenform aufweisen, um optimale Schaltbedingungen für den Ausgangstransistor zu erreichen. Insbesondere bedeutet dies, dass der Basisstrom ein sauberes Ausräumen des Ausgangstransistors sowie einen von Unstetigkeiten freien Abschaltvorgang gewährleisten soll und dabei nur möglichst geringe Verluste im Basiskreis als auch im Kollektorkreis des Transistors in Kauf genommen werden sollen. Um dieses Ziel zu erreichen können unterschiedliche Wege beschritten werden. Ferner kann der im Ausgangstransistor der Steuerschaltung erzeugte Basisstrom, wie aus Fig. 2 ersichtlich, zum Ende des Hinlaufs eine ansteigende oder, wie aus Fig. 3 ersichtlich, eine abfallende Tendenz aufweisen. Dementsprechend muss im Falle einer Basisstromcharakteristik gemäss Fig. 2 die Ausräumzeit länger und bei Verwendung einer Basisstromcharakteristik gemäss Fig. 3 die Ausräumzeit kürzer sein.

Je nachdem welcher Kompromiss in der Dimensionierung in der Zeilenendstufe angestrebt wird, kann der Verlauf des Basisstroms entsprechend Fig. 2 oder der Verlauf entsprechend Fig. 3 oder ein zwischen den in beiden Figuren dargestellten Charakteristiken liegendes zeitliches Verhalten am günstigsten sein. Die gewünschte Kurvenform des Basisstroms erreicht man bei den üblichen Steuerschaltungen für die Horizontalablenkung durch eine entsprechende Dimensionierung des Treibertransformators oder durch parallel zu diesem geschaltete RC-Netzwerke, die entweder auf der Primärseite oder auf der Sekundärseite dieses Treibertransformators angeordnet sein können, oder durch Induktivitäten, Widerstände oder Dioden, die auf die Basis des Ausgangstransistors einwirken.

Erfahrungsgemäss sind nun alle diese bekannten Massnahmen mit einem relativ grossen Aufwand verbunden und verursachen in der Ansteuerschaltung Verlustleistungen, die bei den üblichen Dimensionierungen im Bereich von 3 bis 8 W liegen.

Es ist nun Aufgabe der Erfindung, eine die genannten Nachteile vermeidende Lösung anzugeben.

Um diese Lösung zu gewährleisten wird gemäss der Erfindung vorgeschlagen, dass zur Erzeugung der für die Beaufschlagung der Steuerelektrode des Ausgangstransistors vorgesehenen Steuersignale ein — insbesondere auf Halbleiterbasis hergestellter — Digitalspeicher vorgesehen und die von diesem abgegebenen Steuersignale über ein Drossel an die Steuerelektrode des Ausgangstransistors gelegt sind und dass der die Steuersignale liefernde Digitalspeicher binär derart programmiert ist, dass im Zusammenwirken mit der Drossel und anderen Elementen der Schaltung aus der vom Speicher ausgelesenen Reihenfolge von Impulsen der für die Steuerung des Ausgangstransistors erforderliche Verlauf des Steuersignals ohne zusätzliche Verwendung eines D/A-Wandlers entsteht.

Demzufolge ist bei der erfindungsgemässen Steuerschaltung die für die Erzielung des auf der anderen Seite der Drossel an den Ausgangstransistors abzugebenden Basisstroms erforderliche Kurvenform des Steuersignals gewissermassen in einem Halbleiterspeicher festgehalten. Aus diesem Speicher wird in jedem der einzelnen Ablenkvorgänge das Impulsmuster ausgelesen und — z.B. über eine Treiberstufe — an den Eingang der Drossel und damit auf die Basis des Ausgangstransistors gegeben. Das Impulsmuster kann dem jeweiligen Bedarf ohne Schwierigkeiten angepasst werden. Günstig ist die Verwendung eines programmierbaren Speichers, da man dann den Speicher entsprechend dem jeweiligen Bedarf umprogrammieren kann.

Die Dauer der einzelnen Impulse liegt in der Grössenordnung von 0,1 bis 4 μs. Durch die immer vorhandene Serieninduktivität, die das Abschalten des Transistors verbessert, wird automatisch in Verbindung mit der Eingangskapazität des Ausgangstransistors eine Glättung des Eingangsstromes erreicht, so dass dank der Anwesenheit der Drossel von der Anwendung eines Digital/Analogwandlers zwischen dem Speicher und der Basis des Ausgangstransistors abgesehen werden kann. Der Ausgangstransistor wird dann in üblicher Weise betrieben. Die Treiberstufe kann, wie bisher mit einem Treibertransistor und einem Treibertransformator betrieben werden. Man kann aber auch den Treibertransformator durch eine Gleichstromkopplung ersetzen. Schliesslich ist auch der Ersatz der Treiberstufe durch eine Kondensatorkopplung möglich, was im Interesse des geringeren Aufwands eine besondere Bedeutung hat.

Zum einschlägigen Stand der Technik ist folgendes festzustellen.

In der US-PS Nr. 3801857 ist eine Steuerschaltung mit einem Eingangstransistor und einem Ausgangstransistor beschrieben, die für die Steuerung der Horizontalablenkung eines Fernsehgeräts vorgesehen ist. Die zur Steuerung der Basis des Eingangstransistors vorgesehenen Signale werden von einem üblichen Horizontaloszillator erzeugt. Ein Speicher zur Erzeugung der Steursignale ist jedoch nicht vorgesehen. Dies bedingt aber einen beträchtlichen Aufwand an Schaltungsmitteln, insbesondere an Kondensatoren und Dioden. Ausserdem sind auch hier die von der Erfindung überwundenen Nachteile gegeben.

In der Literaturstelle „Elektronik 1976 H. 3, S. 92 ff" ist ein digitaler Sinusgenerator beschrieben, bei dem die von einem digitalen Festwertspeicher in digitaler Form gelieferten Steuerdaten unter Vermittlung eines D/A-Wandlers in ein analoges sinusförmiges Signal übergeführt werden. Die vorliegende Erfindung hat jedoch das Ziel, ohne einen solchen Wandler auszukommen, was aufgrund der Verwendung einer Drossel zwischen dem Ausgang des Speichers und dem Steuereingang des Ausgangstransistors bei der erfindungsgemässen Schaltung erreicht wird.

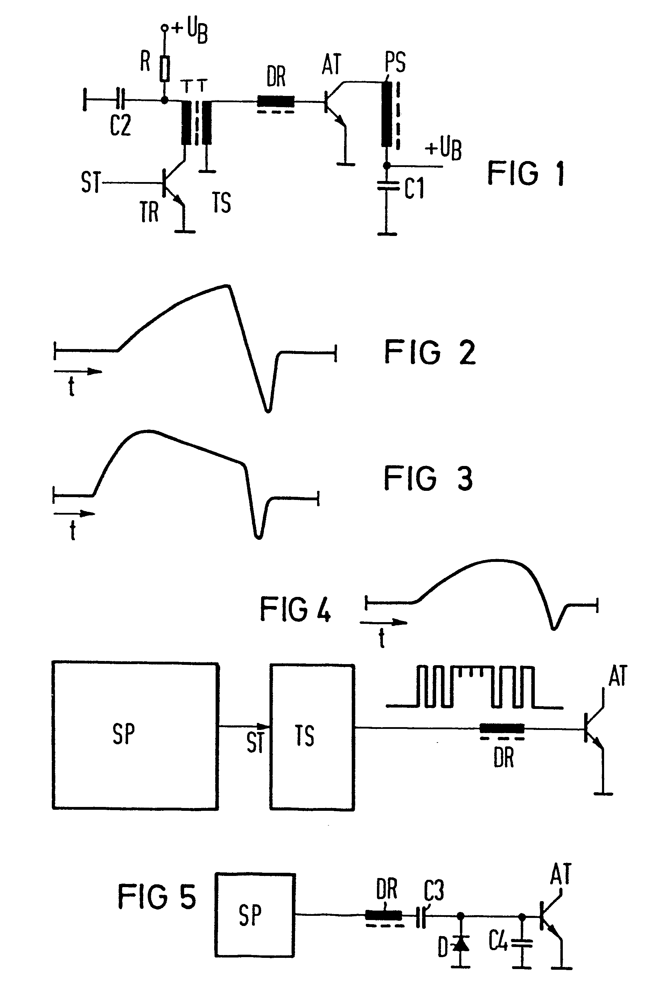

Die Erfindung wird nun anhand der Fig. 1 bis 5 näher beschrieben. In Fig. 1 ist die übliche Ansteuerung des Ausgangstransistors dargestellt. Fig. 2 und 3 zeigen, wie bereits erwähnt, den für die Anwendung der Steuerschaltung in einer Horizontalablenkungsschaltung erwünschten Verlauf des Basisstroms des Ausgangstransistors. Fig. 4 zeigt eine erste Ausführungsform und Fig. 5 eine zweite Ausführungsform der erfindungsgemässen Steuerschaltung.

Bei der in Fig. 1 dargestellten Steuerschaltung entsprechend dem Stand der Technik ist der Ausgangstransistor AT mit seiner Basis über eine Drossel DR an die Sekundärseite des Treibertransformators TT einer Treiberstufe TS angeschlossen. Der den Ablenkstrom liefernde Ausgang des im Beispielsfalle als npn-Transistor ausgestalteten Ausgangstransistors ist durch den Emitter und den Kollektor dieses Transistors AT gegeben. Dabei liegt der Emitter am Bezugspotential (Masse) und der Kollektor über die Primärspule PS des Ablenktransformators am ersten Betriebspotential $+U_B$. Ausserdem ist der am ersten Betriebspotential liegende Anschluss der Primärspule PS über einen Kondensator C1 an das Bezugspotential gelegt.

Die Primärwicklung des Treibertransformators TT ist mit ihrem einen Anschluss über einen Widerstand R an das erste Betriebspotential und gleichzeitig über einen Kondensator C2 an Masse gelegt. Der andere Anschluss der Primärseite des Treibertransformators TT liegt am Kollektor des Treibertransistors TR, ebenfalls eines npn-Transistors, dessen Emitter mit dem Bezugspotential verbunden ist, während seine Basis den Steuereingang ST der Treiberstufe TS bildet. Der Steuereingang ST der Treiberstufe TS wird so beaufschlagt, dass der resultierende Basisstrom für den Ausgangstransistor z.B. das aus Fig. 2 oder das aus Fig. 3 ersichtliche Verhalten zeigt.

Bei dem in Fig. 1 gezeigten Beispiel der bekannten Steuerschaltung ist die Basiselektrode als Steuerelektrode verwendet. Die Steuerelektrode kann aber auch durch die Emitterelektrode des Transistors AT gegeben sein. Ein entsprechendes Beispiel ist in „Siemens-Bauteile-Informationen" 9 (1971), H. 5, S. 135-140, beschrieben.

Gemäss der Erfindung wird nun die in Fig. 1 dargestellte bekannte Steuerschaltung für die Horizontalablenkung durch einen Digitalspeicher SP ergänzt, dessen Informationsausgang zur Beaufschlagung des Steuereingangs ST der Treiberstufe TS vorgesehen ist. Der Digitalspeicher SP ist bevorzugt als Halbleiterspeicher ausgestaltet und kann z.B. mit dem Transistor TR der Treiberstufe TS monolithisch zusammengefasst sein. Es ist verständlich, dass der Speicher SP sowohl als Festwertspeicher als auch als programmierbarer Speicher ausgebildet sein kann. Die im Speicher SP vorliegende binäre Programmierung ist so getroffen, dass im Zusammenwirken mit der Treiberstufe TS und der Drossel DR aus den beim Auslesen des Speichers SP von diesem abgegebenen Impulsen der gewünschte Verlauf des Basistroms für den Ausgangstransistor AT resultiert.

Zur Vereinfachung der Treiberstufe TS kann der Treibertransformator TT weggelassen werden und der Kollektor des Treibertransistors TR unmittelbar mit dem Eingang der Drossel DR sowie mit dem zwischen dem Widerstand R und dem Kondensator C2 liegenden Schaltungspunkt verbunden sein. Schliesslich kann, wie aus Fig. 5 ersichtlich, unter gänzlichem Fortfall der Treiberstufe TS der Ausgang des Digitalspeichers SP über die Drossel DR an den einen Pol eines Kondensators C3 gelegt sein, dessen anderer Pol die Verbindung zur Basis des Ausgangstransistors AT bildet.

Im Beispielsfall sind die verwendeten Transistoren, insbesondere der Ausgangstransistor AT, als Bipolartransistoren ausgestaltet. Zu erwähnen ist dabei, dass auch der Einsatz von pnp-Transistoren sowie von Feldeffekttransistoren, insbesondere vom MOS-Typ, möglich ist. Ferner ist es nicht zwingend, dass der Ausgangstransistor AT, wie bei den beschriebenen Baispielen, in Emitterschaltung betrieben wird.

Der Speicher SP kann so ausgestaltet sein, dass er die zur Steuerung des Ausgangstransistors AT benötigten Signale durchwegs diskreter Binärimpulse liefert, was wohl am häufigsten zutreffend ist. Er kann aber auch so ausgestaltet sein, dass die anfallenden Steuerimpulse im sog. Biphasecode erscheinen.

Wenigstens bei Abwesenheit einer Treiberstufe TS mit Treibertransistor TT empfiehlt es sich, wenn die Steuerelektrode des Ausgangstransistors AT der am Bezugspotential liegenden Elektrode dieses Transistors, also im Beispielsall gemäss Fig. 5 mit der Emitterelektrode, durch eine in Sperrichtung gepolte Diode D einen Kondensator C4 verbunden ist, um den Gleichstrommittelwert des Steuerstroms zu gewährleisten.

Neben der Anwendung der erfindungsgemässen Steuerschaltung für die Horizontalablenkung in Farbfernsehempfängern sind noch weitere Möglichkeiten des Einsatzes dieser Schaltung gegeben. So kann sie z.B. auch zur Ansteuerung eines Schaltnetzteiles, z.B. eines Sperrwandler-Netzteiles, wie er ebenfalls für Fernsehzwecke eingesetzt wird, Verwendung finden.

## Patentansprüche

1. Elektronische Steuerschaltung für die Horizontalablenkung eines Fernsehgerätes bzw. für ein Schaltnetzteil, bei der die Steuerelektrode eines den Ausgangstrom der Steuerschaltung liefernden Ausgangstransistors durch wenigstens ein einen zeitlich veränderlichen Strom über die Steuerelektrode hervorrufendes Steuersignal beaufschlagt ist, dadurch gekennzeichnet, dass zur Erzeugung den für die Beaufschlagung der Steuerelektrode des Ausgangstransistors (AT) vorgesehenen Steuersignale ein — insbesondere auf Halbleiterbasis hergestellter — Digitalspeicher (SP) vorgesehen und die von diesem abgegebenen Steuersignale über eine Drossel (DR) an die Steuerelektrode des Ausgangstransistors (AT) gelegt sind, dass ausserdem der Digitalspeicher (SP) binär derart programmiert ist, dass im Zusammenwirken mit der Drossel (DR) und anderen Elementen der Schaltung aus der vom Speicher (SP) ausgelesenen Reihenfolge von Impulsen der für die Steuerung des Ausgangstransistors (AT) erforderliche Verlauf des Steuersignals ohne zusätzliche Verwendung eines Digital/Analogwandlers entsteht.

2. Elektronische Steuerschaltung nach Anspruch 1, dadurch gekennzeichnet, dass vom Digitalspeicher (SP) abgegebenen Steuersignale der Steuerelektrode des Ausgangstransistors (AT) unter Vermittlung einer Treiberschaltung (TS) zugeführt sind.

3. Elektronische Steuerschaltung nach den Ansprüchen 1 oder 2, dadurch gekennzeichnet, dass der Drossel (DR) ein Kondensator (C3) nachgeschaltet ist.

4. Elektronische Steuerschaltung nach einem der Ansprüche 1 bis 3, dadurch gekennzeichnet, dass der Ausgangstransistor (AT) durch einen Bipolartransistor z.B. vom npn-Typ gegeben ist.

5. Elektronische Steuerschaltung nach Anspruch 4, dadurch gekennzeichnet, dass der Ausgangstransistor in Emitterschaltung betrieben und seine Basiselektrode als Steuerelektrode verwendet ist.

6. Elektronische Steuerschaltung nach den Ansprüchen 4 oder 5, dadurch gekennzeichnet, dass die Basis des Ausgangstransistors (AT) mit der Kathode einer Diode (D) verbunden ist, deren Anode mit der am Bezugspotential (Masse) liegenden Elektrode, insbesondere dem Emitter, des Ausgangstransistors (AT) verbunden ist.

7. Elektronische Steuerschaltung nach einem der Ansprüche 1 bis 6, dadurch gekennzeichnet, dass die am Bezugspotential (Masse) liegende stromführende Elektrode des Ausgangstransistors mit der Steuerelektrode dieses Transistors durch einen Kondensator (C4) verbunden ist.

## Revendications

1. Circuit de commande électronique pour le balayage horizontal d'un appareil de télévision ou pour un élément de réseau de commutation, dans lequel l'électrode de commande d'un transistor de sortie, délivrant le courant de commande du circuit de commande, est chargée par au moins un signal de commande provoquant la délivrance d'un courant, variable dans le temps, par l'intermédiaire de l'électrode de commande, caractérisé par le fait que pour la production des signaux de commande destinés à charger l'électrode de commande du transistor de sortie (AT), il est prévu une mémoire numérique (SP) — réalisée en particulier au moyen de semiconducteurs — et les signaux de commande délivrés par cette mémoire sont appliqués, par l'intermédiaire d'une bobine d'arrêt (DR), à l'électrode de commande du transistor de sortie (AT), qu'en outre la mémoire numérique (SP) est programmée en binaire de telle sorte qu'en coopération avec la bobine d'arrêt (DR) et d'autres éléments du circuit, on obtient, à partir de la suite d'impulsions lue hors de la mémoire (SP), la variation du signal de commande, qui est nécessaire pour la commande du transistor de sortie (AT), sans l'utilisation supplémentaire d'un convertisseur numérique/analogique.

2. Circuit de commande électronique suivant la revendication 1, caractérisé par le fait que des signaux de commande délivrés par la mémoire numérique (SP) sont envoyés à l'électrode de commande du transistor de sortie (AT) par l'intermédiaire d'un circuit d'attaque (TS).

3. Circuit de commande électronique suivant l'une des revendications 1 ou 2, caractérisé par le fait qu'un condensateur (C3) est branché en aval de la bobine d'arrêt.

4. Circuit de commande électronique suivant l'une des revendications 1 à 3, caractérisé par le fait que le transistor de sortie (AT) est formé par un transistor bipolaire, par exemple du type npn.

5. Circuit de commande électronique suivant la revendication 4, caractérisé par le fait que le transistor de sortie fonctionne en émetteur commun et que son électrode de base est utilisée comme électrode de commande.

6. Circuit de commande électronique suivant l'une des revendications 4 ou 5, caractérisé par le fait que la base du transistor de sortie (AT) est reliée à la cathode d'une diode (D), dont l'anode est reliée à l'électrode placée au potentiel de référence (masse), notamment à l'émetteur du transistor de sortie (AT).

7. Circuit de commande électronique suivant l'une des revendications 1 à 6, caractérisé par le fait que l'électrode d'alimentation, placée au potentiel de référence (masse) du transistor de sortie, est reliée à l'électrode de commande de ce transistor par un condensateur (C4).

## Claims

1. An electronic control circuit for horizontal deflection in a television set or for a switching network component, as the case may be, wherein the control electrode of an output transistor which supplies the output current for the control circuit is triggered by at least one control signal which causes a time-modifiable current across the control electrode, characterised in that a digital store (SP), in particular produced on a semiconductor base, is provided in order to produce the control signals provided for triggering the control electrode of the output (AT), and the control signals emitted therefrom are connected *via* a choke (DR) to the control electrode of the output transistor (AT), that furthermore the digital store (SP) is programmed in such a binary manner that in cooperation with the choke (DR) and other elements of the circuit, the course of the control signal required for the control of the output transistor (AT), is produced from the sequence of pulses read out from the store (SP) without additional use of a digital/analogue converter.

2. An electronic control circuit as claimed in claim 1, characterised in that control signals emitted by the digital store (SP) are fed to the control electrode of the output transistor (AT) through a driver circuit (TS).

3. An electronic control circuit as claimed in one of claims 1 or 2, characterised in that the choke (DR) is followed by a capacitor (C3).

4. An electronic control circuit as claimed in one of claims 1 to 3, characterised in that the output transistor (AT) is a bipolar transistor, e.g. of the npn-type.

5. An electronic control circuit as claimed in claim 4, characterised in that the output transistor is operated as a common emitter circuit and its base electrode is used as a control electrode.

6. An electronic control circuit as claimed in one of claims 4 or 5, characterised in that the base of the output transistor (AT) is connected to the cathode of a diode (D), whose anode is connected to the electrode of the output transistor (AT) connected to reference potential (earth), and in particular to the emitter.

7. An electronic control circuit as claimed in one of claims 1 to 6, characterised in that the current-carrying electrode of the output transistor, which is connected to reference potential (earth), is connected to the control electrode of this transistor by means of a capacitor (C4).

0 045 882

FIG 1

FIG 2

FIG 3

FIG 4

FIG 5

7